# EUROPEAN PATENT SPECIFICATION

(11) **EP 0 700 238 B1**
(45) Date of publication and mention of the grant of the patent: **02.07.2003**
(21) Application number: 95105305.7
(22) Date of filing: 07.04.1995
(51) Int. Cl.: H05K 3/02, H05K 1/09, C23F 11/14

(54) **Copper foil for use in making printed wiring board**
Kupferfolie zur Herstellung einer Leiterplatte
Feuille de cuivre pour la fabrication d'une plaque à circuit imprimé

(30) Priority: 30.08.1994 JP 22740694
(43) Date of publication of application: 06.03.1996
(73) Proprietor: MITSUI MINING & SMELTING CO., LTD., Tokyo 103 (JP)
(72) Inventor: Dobashi, Makoto, Ageo-shi, Saitama (JP); Yokota, Toshiko, Ageo-shi, Saitama (JP); Hata, Hiroshi, Kawagoe-shi, Saitama (JP); Tsuyoshi, Hiroaki, Omiya-shi, Saitama (JP); Ohara, Muneharu, Hasuda-shi, Saitama (JP)
(74) Representative: Grünecker, Kinkeldey, Stockmair & Schwanhäusser Anwaltssozietät

(56) References cited:
- EP-A- 0 490 161
- CH-A- 495 434
- GB-A- 2 102 453
- PATENT ABSTRACTS OF JAPAN vol. 18, no. 340 (E-1569) 27 June 1994 & JP-A-06 085 417 (NIKKO GUURUDO FOIL KK) 25 March 1994
- PATENT ABSTRACTS OF JAPAN vol. 18, no. 340 (E-1569) 27 June 1994 & JP-A-06 085 455 (NIKKO GUURUDO FOIL KK) 25 March 1994
- PATENT ABSTRACTS OF JAPAN vol. 15, no. 484 (C-0892) 9 December 1991 & JP-A-03 211 298 (CHIYODA KAGAKU KENKYUSHO KK) 17 September 1991

## Description

### BACKGROUND OF THE INVENTION

### 1. Field of the Invention

This invention relates to a copper foil for use in making a printed wiring board and more specifically it relates to a copper foil which prevents the sticking thereto of a dust mainly containing epoxy resin fine particles during the adhesion of the copper foil onto a substrate for use as a board for forming printed wiring thereon and which, in addition, will not cause its discoloration for a longer time than a conventional one when subjected to soldering.

### 2. Prior Art

In a conventional method for the manufacture of a printed wiring board, a copper foil and a substrate which is illustrated by a glass fiber substrate impregnated with an epoxy resin, are first adhered to each other under heat and pressure or by other means. After a photomask and the like are applied to the copper foil so adhered to the substrate, portions of the copper foil which are not needed for the formation of a conductive circuit are removed by an acidic or alkaline etching solution.

The adhesion of the copper foil to the substrate under said "heat and pressure" is carried out as follows. The copper foil is put on the epoxy resin-impregnated glass fiber substrate or the like to form a laminate. A plurality of such laminates are piled one upon another with a stainless steel plate interposed between any adjacent two laminates as a separator, after which the laminates so piled are pressed together at a predetermined "heat and pressure" for a predetermined time whereby the copper foil and the substrate in each of the laminates are adhered together (for example, Printed Circuits Handbook, Second Edition, CLYDE F. COOMBS Jr., published in 1979). If, at this moment, fine particles of an epoxy resin or a dust (namely, a dust containing fine particles of the epoxy resin as its main component) in the air sticks on the face of the copper foil, which face is not adhered to the substrate (such a face being hereinafter referred to as a "non-adhesive face or surface"), the dust will be strongly stuck on said non-adhesive face by pressing under heat. This strongly stuck dust will hinder etching during the subsequent formation of a conductive circuit. Such hindrance has raised a serious problem as it causes a short-circuit on the printed wiring board obtained. Hereinafter, a phenomenon of such a dust being strongly stuck is referred to as "resin spots" or "resin marks".

Moreover, the rust-proofing treatment of the non-adhesive face of the copper foil has conventionally been accomplished by forming thereon a layer of zinc or a zinc alloy together with a chromate treated layer. However, in order to prevent the discoloration of the copper foil for a long time during the soldering treatment thereof, it has been needed that a considerably large quantity of zinc or a zinc alloy is electrodeposited on the surface of the copper foil, whereby the tint thereof has disadvantageously been made bluish.

Conventionally, the non-adhesive face (side) of a starting copper foil to be used in making a printed wiring board is electroplated with a very small amount of zinc or a zinc alloy to prevent the copper foil from causing its discoloration which is otherwise caused by heat during the adhesion between the foil and substrate under heat and pressure (see e.g. JP-A-06 085 417 and JP-A-06 085 455). After the electroplating, this face is further subjected to chromate treatment so that it becomes rust-proof. In ordinary electrolytic copper foils, their glossy face, which faced the electrode during the electrolysis, is very often used as the non-adhesive face.

### SUMMARY OF THE INVENTION

The primary object of this invention is to provide a novel copper foil for use in making a printed wiring board, which prevents the formation of resin spots thereon when the copper foil and substrate are bonded or adhered together and which does not cause its discoloration for a longer time when subjected to soldering, thus solving the aforesaid conventional problems.

The above object of this invention is achieved by forming a zinc or zinc alloy layer on the non-adhesive face (which is not to be adhered to a substrate) of a copper foil, further forming a chromate-treated layer on said metallic layer as required, and then subjecting said metallic layer or else said chromate-treated layer to organic rust-proof treatment with an aminotriazole isomer.

The copper foil for use in making a printed wiring board according to this invention is defined in claim 1.

The treatments carried out on the adhesive face of the copper foil which is to be adhered to the substrate will be explained later.

The copper foil for use in making a printed wiring board according to the present invention will be described hereunder in more detail.

The copper foil for use in making a printed wiring board according to the present invention has two faces (sides), one being the adhesive face which is adhered onto the substrate and the other being the non-adhesive face which is not adhered onto the substrate. According to the present invention, the copper foil has a zinc layer or a zinc alloy layer on its non-adhesive face. The zinc or zinc alloy layer may be formed by any of various known methods using plating such as electroplating. The above mentioned zinc or zinc alloy layer may be any plating as far as the main component of the plating is zinc. A zinc plating and various zinc alloy platings such as a zinc-tin alloy plating may be used and, further, these platings may be incorporated with a very small amount of a metal (a third metal) other than the above alloying metal.

There is exemplified a plating method in which are used a zinc alloy electroplating bath of the following composition and a set of plating conditions:

### (Zn-Sn Electroplating)

| | |
|---|---|
| Tin pyrophosphate | 1 - 5 g/l |
| Zinc pyrophosphate | 1 - 10 g/l |
| Potassium pyrophosphate | 100 g/l |
| pH | 9 - 12 |
| Solution temperature | Room temperature |
| Current density | 0.1 - 1 A/dm² |

As far as any other plating methods give the same layer of zinc or a zinc alloy on the same coper foil, they may be used to obtain the same result as the above.

Furthermore, the copper foil of this invention may have a chromate-treated layer formed on the above mentioned zinc or zinc alloy layer which is formed on the non-adhesive face of the copper foil. Such a chromate-treated layer may be formed by a conventionally used chromate treatment method.

There are exemplified hereunder the composition of a chromate treatment solution and a set of treatment conditions:

### (Chromate Treatment)

| | |
|---|---|
| Chromic acid | 0.05 - 10 g/l |
| pH | 9 - 13 |
| Current density | 0.1 - 1 A/dm² |

The composition of this chromate treatment solution and the treatment conditions shown above are only illustrative. As far as the same chromate treated layer as above can be formed on the zinc or zinc alloy layer with the use of other compositions and treatment conditions, these other compositions and treatment conditions may also be used without being limited to the above illustrative ones.

The copper foil of the present invention has organic rust-proof treatment with aminotriazole isomers applied on the surface of the aforesaid zinc or zinc alloy layer; or it has organic rust-proof treatment with aminotriazole isomers applied on the surface of the aforesaid chromate treated layer which has been deposited on the aforesaid zinc or zinc alloy layer. The organic rust-proof treatment with aminotriazole isomers according to the present invention is a treatment with an aqueous solution of said compounds. Concretely, the organic rust-proof treatment may be carried out by immersion in said solution, spray-coating thereof, roll-coating thereof, and the like.

As aminotriazole isomers, for example, 2-amino-1,3,4-triazole, 4-amino-1,2,4-triazole, and 1-amino-1,3,4-triazole may be preferably used.

The preferable concentration of the aminotriazole isomers to be used may be in the range of from about 0.1 to about 50 g/l. No effect can be recognized if the concentration is less than 0.1 g/l, while the concentration of more than 50 g/l tends to be uneconomical although it is effective. It is preferred that the temperature for treatment with aminotriazole isomers be from room temperature to about 50 °C and the treatment time be from about 1 second to about 2 minutes. Under the above-mentioned conditions, the amount of aminotriazole isomers stuck on the surface of the zinc or zinc alloy layer or of the chromate treated layer is about 0.1 to about 10 mg/m².

A starting copper foil used as a material for the copper foil of the present invention may be any one of an electrolytic copper foil, rolled copper foil, and the like. There is no special limitation on the thickness and the like of the starting copper foil.

According to the present invention, the adhesive face of the starting copper foil, which is to be adhered onto the substrate, is subjected to the following ordinary treatments: a nodular copper layer is first formed on the adhesive face of the starting copper foil, a zinc or zinc alloy layer is then formed on said nodular copper layer by plating, and a chromate-treated layer is further formed on said zinc or zinc alloy layer to ensure rust-proofing for improvement of the foil in chemical resistance. Usually, the zinc or zinc alloy layer and the subsequent chromate-treated layer are respectively formed simultaneously on both the adhesive face and the non-adhesive face of the starting copper foil. However, the treatment with aminotriazole isomers is not carried out on the adhesive face.

As explained above, the copper foil for use in making a printed wiring board according to the present invention has a zinc or zinc alloy layer formed on its non-adhesive face which is not to be adhered onto the substrate, after which the zinc or zinc alloy layer is subjected to organic rust-proof treatment with aminotriazole isomers. Alternatively, after the formation of the zinc or zinc alloy layer on the non-adhesive face, a chromate-treated layer is formed on the zinc or zinc alloy layer and then subjected to organic rust-proof treatment with aminotriazole isomers. Aminotriazole isomers used herein has heat resistance, and is incompatible with resins such as an epoxy resin. Therefore, in a case where there is used the copper foil of this invention which has been subjected to organic rust-proof treatment with aminotriazole isomers as described above, a dust mainly containing powdered epoxy resin will be fully prevented from sticking onto the copper foil when the copper foil and the substrate for the printed wiring board are adhered to each other and, further, the copper foil will be prevented from causing its discoloration for a longer time than a conventional one when subjected to soldering.

### DESCRIPTION OF THE PREFERRED EMBODIMENT

### Example 1

A nodular copper layer was formed, by an ordinary treatment, on the adhesive face (to be adhered onto a substrate) of a starting ordinary (standard) electrolytic copper foil (35 µm thick), and a zinc alloy electrodeposited layer comprising 20 mg/m² of zinc and 5 mg/m² of tin was then formed on said nodular copper layer, after which the zinc alloy layer so formed was subjected to treatment with chromic acid or a chromate and further to treatment with a silane coupling agent, while a zinc alloy electrodeposited layer comprising 5 mg/m² of zinc and 1 mg/m² of tin was formed on the non-adhesive face (not to be adhered onto the substrate) of the starting copper foil, the treatment with chromic acid was omitted by shutting off the electric current, and said zinc alloy layer was subjected to organic rust-proof treatment by showering a solution of 3 g/l of 3-amino-1,2,4-triazole onto said zinc alloy layer.

The bath composition and treating conditions used for each of the above zinc alloy electroplating treatment, chromate treatment and silane coupling agent treatment, were as follows.

### Zn-tin plating bath

### 1. (For the adhesive face)

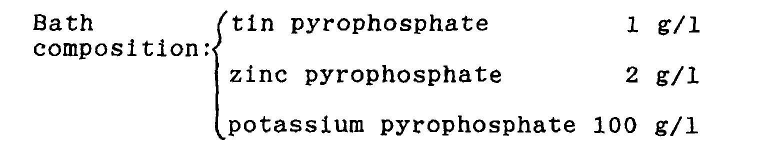

pH: 10.5
Temperature: room temperature
Current density: 0.5 A/dm²
Time: 6 sec.

### 2. (For the non-adhesive face)

The bath composition, pH and temperature were the same as those for the adhesive face.
Current density: 0.15 A/dm²
Time: 6 sec.

### Chromate-treatment

### (For the adhesive face)

Bath composition: CrO₃ 2 g/l
pH: 10.0
Current density: 0.5 A/dm²
Time: 5 sec.

### Silane coupling agent-treatment

### (For the adhesive face)

Showering of a 5 g/l aqueous solution of γ-glycidoxypropyl trimethoxysilane onto chromate-treated layer for 5 seconds.

### Example 2

A nodular copper layer was formed, by an ordinary treatment, on the adhesive face of a starting ordinary electrolytic copper foil (35 µm thick), and a zinc alloy electrodeposited layer comprising 20 mg/m² of zinc and 5 mg/m² of tin was formed on said nodular copper layer, after which the zinc alloy layer so formed was subjected to treatment with a chromate and then to treatment with a silane coupling agent, while a zinc alloy electrodeposited layer comprising 5 mg/m² of zinc and 1 mg/m² of tin was formed on the non-adhesive face of the starting copper foil, the zinc alloy layer so formed was subjected to treatment with a chromate, and the chromate-treated layer thus formed was subjected to organic rust-proof treatment by showering a 3 g/l solution of 3-amino-1,2,4-triazole onto said chromate-treated layer.

The bath composition and treating conditions used for each of the above zinc alloy electroplating, chromate treatment and silane coupling agent treatment were the same as those used in Example 1.

### Example 3 (Preferred embodiment)

A nodular copper layer was formed, by an ordinary treatment, on the adhesive face of a starting ordinary electrolytic copper foil (35 µm thick), and a zinc electrodeposited layer comprising 400 mg/m² of zinc was formed on said nodular copper layer, after which the zinc layer so formed was subjected to treatment with a chromate and then to treatment with a silane coupling agent, while a zinc electrodeposited layer comprising 10 mg/m² of zinc was formed on the non-adhesive face of the starting copper foil and then subjected to organic rust-proof treatment by showering a 10 g/l solution of 2-amino-1,3,4-triazole onto said zinc electrodeposited layer.

The bath composition and treating conditions used for each of the chromate treatment and the silane coupling agent treatment were the same as those used in Example 1. The bath composition and treating conditions used for the zinc plating were as follows.

### Zn plating bath

### 1. (For the adhesive face)

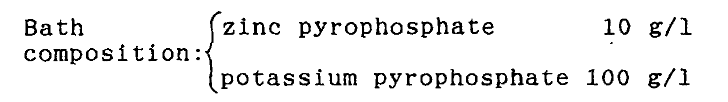

pH: 11.0
Temp.: room temperature
Current density: 5 A/dm²
Time: 6 sec.

### 2. (For the non-adhesive face)

The bath composition, pH and temperature were the same as those used for the adhesive face.
Current density: 0.4 A/dm²
Time: 6 sec.

### Comparative Example 1

A nodular copper layer was formed, by an ordinary treatment, on the adhesive face of a starting ordinary electrolytic copper foil (35 µm thick), and a zinc alloy electrodeposited layer comprising 20 mg/m² of zinc and 5 mg/m² of tin was formed on said nodular copper layer, after which the zinc alloy layer so formed was subjected to treatment with a chromate and then to treatment with a silane coupling agent, while a zinc alloy electrodeposited layer comprising 5 mg/m² of zinc and 1 mg/m² of tin was formed on the non-adhesive face of the starting copper foil and then subjected to treatment with a chromate.

The bath composition and treating conditions used for each of the above zinc alloy electroplating, chromate treatment and silane coupling agent treatment were the same as those used in Example 1.

### Comparative Example 2

A nodular copper layer was formed, by an ordinary treatment, on the adhesive face of a starting ordinary electrolytic copper foil (35 µm thick), and a zinc electrodeposited layer comprising 400 mg/m² of zinc was formed on said nodular copper layer, after which the zinc layer so formed was subjected to treatment with a chromate and then to treatment with a silane coupling agent, while a zinc electrodeposited layer comprising 25 mg/m² of zinc was formed on the non-adhesive face of the starting copper foil and then subjected to treatment with a chromate followed by being treated with a silane coupling agent.

The bath composition and treating conditions used for each of the above zinc electroplating, chromate treatment and silane coupling agent treatment, effected on the adhesive and non-adhesive faces, were the same as those used in Example 3 except that the current density used for plating of the non-adhesive face with zinc was 0.6 A/dm² in Comparative Example 2.

The copper foils obtained from the above Examples 1 - 3 and Comparative Examples 1 - 2 were evaluated for their resin mark resistance and soldering heat resistance by the methods shown below. The contents of the rust-proof elements and the results obtained are shown in Table 1.

### (EVALUATION TEST METHODS)

### (Resin Mark Resistance)

Each of the copper foils so obtained was placed on an epoxy-impregnated glass fiber substrate to form a laminate. After powder of an epoxy resin had been spreaded on the non-adhesive face of the copper foil, which was not to be adhered onto the substrate, a plurality of the same laminates as above were piled one upon another with a stainless steel plate inserted between any adjacent two laminates as a separator and then heated and pressed together. The number of epoxy resin spots stuck on each of the stainless steel plates and on the said non-adhesive face of each of the copper foils were visually counted to find the resin mark resistance of the steel plate and non-adhesive face.

### (Soldering Heat Resistance)

With its non-adhesive face facing up, each copper foil obtained was floated on a solder bath kept at 288 °C to visually measure how long (many seconds) it would take to start its discoloration.

**Table 1**

| | Rust-proof element content (mg/m²) | | | | Resin-mark resistance | | Soldering heat resistance (seconds) |
|---|---|---|---|---|---|---|---|
| | Zn | Sn | Cr | Amino triazole | Number of resin-spots stuck on copper foil | Number of resin-spots stuck on stainless steel plate | |
| Example 1 | 5 | 1 | 0 | 0.5 | None | Many | 300 |
| Example 2 | 5 | 1 | 3 | 0.7 | None | Many | 380 |
| Example 3 | 10 | 0 | 0 | 1.2 | None | Many | 600 |
| Comparative Example 1 | 5 | 1 | 3 | 0 | Appreciable | Appreciable | 40 |
| Comparative Example 2 | 25 | 0 | 7 | 0 | Many | few | 240 |

From the test results of the Examples and the Comparative Examples as shown in Table 1, it is clear that much of the epoxy resin dust was stuck on the conventional copper foils (Comparative Examples 1 - 2) having not undergone the organic rust-proof treatment with aminotriazole isomers at their non-adhesive face, when the conventional copper foils were adhered respectively onto substrates for use in making a printed wiring board. In contrast, none of the epoxy resin dust was stuck on the copper foils according to Examples 1 - 3 which had undergone the organic rust-proof treatment with aminotriazole isomers at their non-adhesive face, when the present copper foils were bonded respectively with the substrates.

In addition, the two conventional copper foils used in making a printed wiring board (Comparative Examples 1 - 2) were low in soldering heat resistance whereby they started their discoloration in a relatively short time, while the copper foil of the present invention (Example 3) showed high soldering heat resistance and did not show discoloration for a longer time than the conventional ones during the soldering.

Having described the preferred embodiment of the invention (Example 3), it is to be understood that the invention is not limited to this embodiment, and that various changes and modifications may be effected therein by one skilled in the art without departing from the scope of the invention as defined in the appended claims.

## Claims

1. A copper foil for use in making a printed wiring board, having an adhesive face to be adhered onto a substrate and a non-adhesive face not to be adhered onto the substrate, wherein said non-adhesive face has a metallic layer formed by a metal selected from the group consisting of zinc and a zinc alloy formed thereon, and wherein the metallic layer so formed has a resin spots-preventing layer formed thereon by a compound selected from the group consisting of 2-amino-1,3,4-triazole, 4-amino-1,2,4-triazole and 1-amino-1,3,4-triazole so that resin spots generated during adhesion of the adhesive face onto the substrate are prevented.

2. The copper foil of claim 1, wherein said zinc alloy is a zinc-tin alloy.

3. The copper foil of claim 1, wherein said non-adhesive face further has a chromate-treated layer formed by a chromate between said metallic layer and said resin spots-preventing layer.

## Patentansprüche

1. Kupferfolie zum Einsatz bei der Herstellung einer Leiterplatte, die eine klebende Fläche, die an einem Substrat anzukleben ist, und eine nichtklebende Fläche aufweist, die nicht an dem Substrat anzukleben ist, wobei auf der nichtklebenden Fläche eine Metallschicht, die durch ein Metall gebildet wird, das aus der Gruppe ausgewählt wird, die aus Zink und einer Zinklegierung besteht, ausgebildet ist und wobei die so ausgebildete Metallschicht eine Schicht, die verhindert, dass Harzteilchen an der Oberfläche der Kupferfolie anhaften, aufweist, die darauf durch eine Verbindung ausgebildet ist, die aus der Gruppe ausgewählt wird, die aus 2-Amino-1,3,4-triazol, 4-Amino-1,2,4-triazol und 1-Amino-1,3,4-triazol besteht, so dass das Anhaften von Harzteilchen, das während des Anklebens der klebenden Fläche an dem Substrat bewirkt wird, verhindert wird.

2. Kupferfolie nach Anspruch 1, wobei die Zinklegierung eine Zink-Zinn-Legierung ist.

3. Kupferfolie nach Anspruch 1, wobei die nichtklebende Fläche des Weiteren eine chromatbehandelte Schicht, die durch ein Chromat zwischen der Metallschicht und der Schicht, die verhindert, dass Harzteilchen an der Oberfläche der Kupferfolie anhaften, ausgebildet ist, aufweist.

## Revendications

1. Feuille de cuivre à utiliser pour fabriquer une plaquette à câblage imprimé, ayant une face adhésive qui doit être collée sur un substrat et une face non adhésive qui ne doit pas être collée sur le substrat, dans laquelle ladite face non adhésive a une couche métallique formée d'un métal choisi dans l'ensemble constitué du zinc et d'un alliage de zinc formé sur celle-ci, et dans laquelle la couche métallique ainsi formée a une couche empêchant des points de résine, formée sur celle-ci au moyen d'un composé choisi dans l'ensemble constitué de 2-amino-1,3,4-triazole, 4-amino-1,2,4-triazole et 1 amino-1,3,4-triazole, de sorte que des points de résine formés pendant l'adhérence de la face adhésive sur le substrat sont empêchés.

2. Feuille de cuivre selon la revendication 1, dans laquelle ledit alliage de zinc est un alliage de zinc-étain.

3. Feuille de cuivre selon la revendication 1, dans laquelle ladite face non adhésive a, en outre, une couche traitée au chromate, formée au moyen d'un chromate entre ladite couche métallique et ladite couche empêchant les points de résine.
